Europäisches Patentamt

European Patent Office

Office européen des brevets

(19)

(11) Veröffentlichungsnummer: **0 268 105 B1**

(12) # EUROPÄISCHE PATENTSCHRIFT

(45) Veröffentlichungstag der Patentschrift: **30.09.92**

(51) Int. Cl.⁵: **H03M 1/12**, H03M 1/56, G01R 33/035

(21) Anmeldenummer: **87115536.2**

(22) Anmeldetag: **23.10.87**

(54) **Analog-Digital-Wandler im Temperaturbereich der Supraleitung.**

(30) Priorität: **20.11.86 DE 3639623**

(43) Veröffentlichungstag der Anmeldung:
**25.05.88 Patentblatt 88/21**

(45) Bekanntmachung des Hinweises auf die
Patenterteilung:
**30.09.92 Patentblatt 92/40**

(84) Benannte Vertragsstaaten:
**FR GB**

(56) Entgegenhaltungen:
**EP-A- 0 119 586**
**DE-A- 2 715 062**

(73) Patentinhaber: **DORNIER GMBH**
**Postfach 1420**
**W-7990 Friedrichshafen 1(DE)**

(72) Erfinder: **Kratz, Harald**
**Untere Holunderstaffel 15**
**W-7992 Tettnang(DE)**

(74) Vertreter: **Landsmann, Ralf, Dipl.-Ing.**
**DORNIER GMBH - Patentabteilung - Kleeweg**
**3**
**W-7990 Friedrichshafen 1(DE)**

## Beschreibung

Die Erfindung betrifft einen Analog-Digital-Wandler und ein Verfahren zum Betreiben des Wandlers im Temperaturbereich der Supraleitung.

Die Anwendung von AC-SQUID's und DC-SQUID's (SQUID = Superconductive Quantum Interference Device) bei Messungen des Erdmagnetfeldes, von Herz- und Gehirnwellen und bei Untersuchungen magnetischer Materialien ist aus Elektronik 30 (1981), Heft 12, Seite 26 bekannt.
Aus der DE-C-33 10 245 entsprechend EP-A-0 119 586 ist ein Verfahren und eine Vorrichtung zur Ermittlung von Signalgrößen-Inkrementen bekannt, bei dem mittels einer Josephson-Anordnung als SQUID und einem supraleitenden Leiterkreis und einer Auswertung mittels eines Vorwärts- und Rückwärtszählers die ausgeführte Anzahl der Teilschritte unter Berücksichtigung eines Vorzeichens gezählt wird.

Ebenso wurde in DE-A-3 538 186, veröffentlicht am 30.04.87, bereits ein Verfahren zur direkten Digitalisierung von SQUID-Signalen vorgeschlagen, das darauf beruht, die Zeitdifferenz $\Delta t$ zwischen einer charakteristischen Phasenlage eines periodischen Abtastsignals und dem Auftreten eines Flußquantenübergangs in einem SQUID zu messen. Diese Zeitdifferenz stellt ein Maß für das unbekannte Meßsignal dar und wird in Einheiten der Periodendauer eines hochfrequenten Zähltaktes mit Hilfe eines Zählers gemessen. Da hier eine Zeitdifferenz bestimmt wird, spielt der durch Rauschen verursachte zeitliche emitter der beiden die Zeitdifferenz $\Delta t$ bestimmenden Zeitpunkte sowie die zusätzlichen Auslösezeitpunkte, die von Rauschen, Meßsignal und Abtastsignal abhängen, infolge der internen SQUID-Dynamik eine begrenzende Rolle. Jitter sind zeitliche statistische Schwankungen des Startzeitpunktes eines durch ein Triggersignal ausgelösten Vorganges. Bekannte Methoden der Minimierung des zeitlichen Jitters sind nur begrenzt anwendbar, da die Amplitude des periodischen Abtastsignals funktionsbedingt begrenzt und gegebenenfalls stabilisiert sein muß, und da ebenso die Anstieg- und Abfallzeiten nicht beliebig gewählt werden können. Daneben muß der bei Flußquantenübergängen erzeugte Spannungsimpuls möglichst formgetreu verstärkt werden, was bei Impulsbreiten um 6 ps derzeit äußerst schwierig erscheint. Hinzu kommt, dass die Meßwerte prinzipbedingt zeitlich nicht äquidistant anfallen, was die Zuordnung zwischen Meßzeitpunkt und Meßwert erschwert.

Der Erfindung liegt die Aufgabe zugrunde, ein Verfahren und eine Vorrichtung zu entwickeln, die ermöglicht, analoge Größen wie elektrische Ströme und magnetische Felder mit einer hohen Genauigkeit zu digitalisieren und gegebenenfalls digital zu messen.

Diese Aufgabe wird durch den Analog-Digital-Wandler und das Verfahren zu seinem Betrieb nach den unabhängigen und davon abhängigen Patentansprüchen gelöst.

Beim erfindungsgemäß vorgeschlagenen Verfahren spielt die Phasenlage des Abtastsignals nur eine untergeordnete Rolle und die Problematik der Begrenzung und Stabilisierung der Amplitude des Abtastsignals fällt weitgehend weg. Die Transformation des zu wandelnden Signals in den Zeitbereich geschieht vielmehr durch zeitlich symmetrisch versetztes Schalten zweier DC-SQUID's mit zwei oder mehr Josephson-Kontakten in den quasistationären Spannungszustand. Der Einfluß des zeitlichen Jitters kann deutlich reduziert werden, da der Übersteuerungsgrad groß gewählt werden kann, wodurch Jitter und Einschaltverzögerung reduziert werden. Gleichzeitig läßt sich das Triggersignal für die beiden Interferometer durch Teilung aus einem einzigen Eingangstriggersignal gewinnen, was die Jitterprobleme ebenfalls erheblich reduziert.
Durch eine Aufteilung in zwei Digitalisierungsstufen, zum einen im AC-SQUID und zum anderen in den DC-SQUID's, ist eine hohe Auflösung des Analogsignals erreicherbar. Die Frequenz des zu wandelnden Signals liegt, insbesondere bei der Verwendung von Josephson-Kontakten, im MHz-Bereich. Es ist nicht erforderlich, ps-Impulse zu verstärken, da der Impuls von u(t) relativ breit sein kann und zur Detektion des Spannungsimpluses im AC-SQUID in einer Torschaltung lediglich ein DC-SQUID getriggert und in den Spannungszustand geschaltet werden kann.

Die Erfindung wird anhand von Figuren näher erläutert.
Es zeigen:

Figur 1     eine Prinzipschaltung der Meßvorrichtung,

Figur 2     die Spannung u(t) für verschiedene $\Phi_x(t)$
      a) für $\Phi_x(t) = 0$
      b) für $\Phi_x(t) = \neq 0$

Figur 3     eine Torschaltung und einen Zähler zur Digitalisierung von u(t).

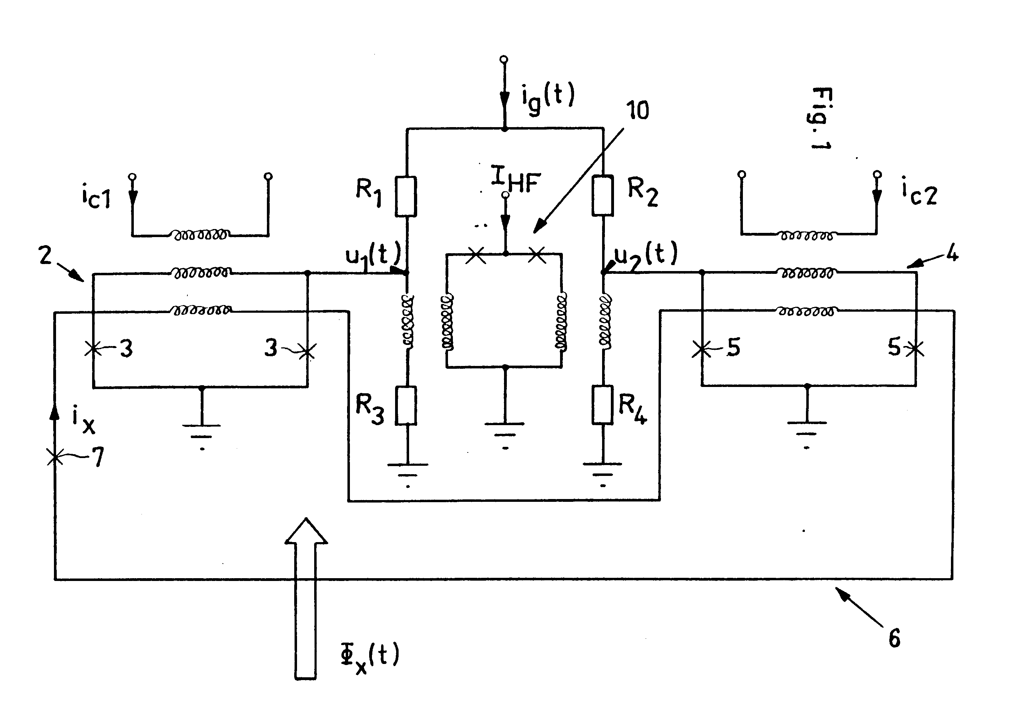

Figur 1 zeigt eine Prinzipschaltung zur direkten digitalen Messung von magnetischen Feldern. Die Schaltung bildet das Grundelement des Verfahrens. Zwei gegeneinander geschaltete DC-SQUID's 2 und 4 mit je zwei Josephson-Kontakten 3 und 5 sind mit einem AC-SQUID 6 mit einem Josephson-Kontakt 7 induktiv gekoppelt. Statt der induktiven Kopplung ist auch eine galvanische Kopplung möglich.

Zur Erklärung der Funktionsweise sei vereinfachend angenommen, dass die Schaltung nach Figur 1 mit einem periodischen dreieckförmigen Signal $i_g(t)$ angesteuert wird, und dass die beiden Steuerströme $i_{c1}$ und $i_{c2}$ gleich Null sind. Ohne externes Meßsignal ($\Phi_x(t) = 0$) ist auch der in die Schleife induzierte Abschirmstrom $i_x(t)$ gleich Null.

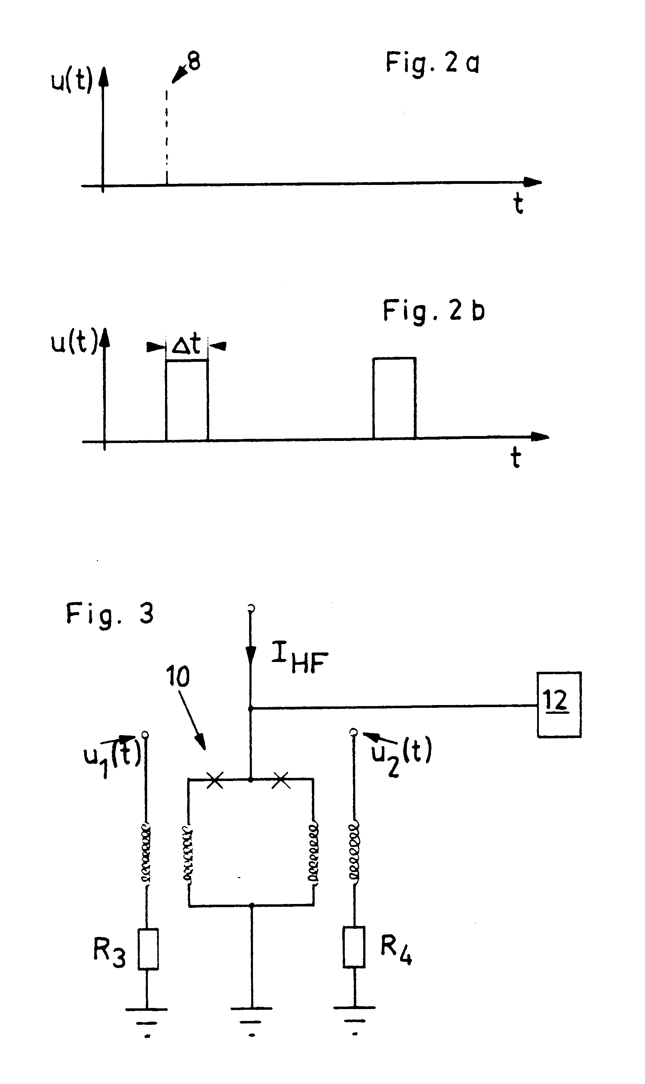

Figur 2a zeigt, dass damit für gleiche Widerstände $R_1$ und $R_2$ und für identische DC-SQUID's 2 und 4 die Spannung $u(t) = u_1(t) - u_2(t)$ stets gleich Null ist. Ausnahmen bilden eventuell auftretende extrem kurze Impulse 8.

Figur 2b zeigt den Fall, dass das externe Meßsignal $\Phi_x(t) \neq 0$ ist. Der in die Schleife induzierte Abschirmstrom $i_x(t)$, der einen zum äußeren Fluß $\Phi_x(t)$ entgegengesetzten Fluß erzeugen kann, führt zu einer symmetrischen Änderung der Schaltzeitpunkte der beiden DC-SQUID's 2 und 4, relativ zur ansteigenden Flanke des dreieckförmigen Signals $i_g(t)$. Pro Periode von $i_g(t)$ entsteht ein Spannungsimpuls $u(t)$, dessen Breite $\Delta t$ von $i_x(t)$ und damit von $\Phi_x(t)$ abhängt. Das unbekannte Meßsignal $\Phi_x(t)$ wird durch dieses Verfahren in die Breite $\Delta t$ des Spannungsimpulses $u(t)$ transformiert. Die erreichbare Genauigkeit hängt von der Flanke des Dreiecksignals $i_g(t)$ sowie von der Anstiegs- und Abfallzeit von $u(t)$ ab. Bezüglich der Anstiegs- und Abfallzeiten bieten Schaltungen mit Josephson-Kontakten wegen ihrer Schaltzeiten im ps-Bereich entscheidende Vorteile. Für $i_{c1}(t)$ und $i_{c2}(t)$ ungleich Null ändert sich am prinzipiellen Verhalten der Schaltung nichts. Diese Steuerströme dienen lediglich dazu, Bauelemente-Toleranzen auszugleichen, sowie der Einstellung einer Grundbreite $\Delta t_0$ für $\Phi_x(t) = 0$.

Figur 3 zeigt eine Torschaltung 10 zur weiteren digitalen Verarbeitung von $u(t)$ (siehe auch Figur 1, Ziffer 10). Für die Dauer $\Delta t$ ist dann das Tor geöffnet. Ein eingespeister hochfrequenter Zähltakt wird in diesem Öffnungszeitraum von einem Zähler 12 gezählt. Der Zählerinhalt pro Periode $i_g(t)$ stellt dann das unbekannte Meßsignal $\Phi_x(t)$ in digitaler Form dar.

Das erfindungsgemäße Verfahren erscheint geeignet als zweite Digitalisierungsstufe bei einer Auflösung größer als 12 bit. Um diese Auflösung noch um beispielsweise weitere 20 bit zu steigern, kann in einer ersten Digitalisierungsstufe die Anzahl der Flußquanten im AC-SQUID 6 gezählt werden. Dazu werden die Spannungsimpulse bei Flußquantenübergängen im AC-SQUID 6 digitalisiert und in einem zweiten Zähler gezählt. Die verwendete Verschachtelung von AC- und DC-SQUID's ermöglicht, dass der Abschirmstrom $i_x(t)$ klein bleiben kann ($|i_x(t)| \leq I_0$ mit $I_0$ = maximaler Josephson-Strom von Josephson-Kontakt 7 in Figur 1).

**Patentansprüche**

1. Analog-Digital-Wandler mit Widerständen, Induktivitäten und SQUID's mit einem oder mehreren Josephson-Kontakten im Temperaturbereich der Supraleitung, **gekennzeichnet durch**
   - eine erste Digitalisierungsstufe aus einem AC-SQUID (6) mit einem (7) oder mehreren ungleichgroßen Josephson-Kontakten und
   - eine zweite Digitalisierungsstufe aus zwei DC-SQUID's (2,4) mit zwei (3,5) oder mehreren Josephson-Kontakten,
   - einer Kopplung zwischen den beiden Digitalisierungsstufen,
   - einer Vorrichtung zur Einspeisung von periodischen, dreieckförmigen Signalen und
   - wenigstens einer Zählvorrichtung (12) zur Bestimmung der Anzahl und/oder Breite der vom zu wandelnden Analogsignal abhängigen Spannungsimpulse.

2. Analog-Digital-Wandler nach Anspruch 1, **dadurch gekennzeichnet,** daß die erste Digitalisierungsstufe induktiv an die zweite Digitalisierungsstufe angekoppelt ist und dadurch der Strom in der zweiten Digitalisierungsstufe auf Werte kleiner oder gleich dem maximalen Josephson-Strom des kleinsten der Josephson-Kontakte der ersten Digitalisierungsstufe begrenzt ist.

3. Analog-Digital-Wandler nach einem der Ansprüche 1 oder 2, **dadurch gekennzeichnet,** daß sie in einem Chip integriert ist.

4. Verfahren zum Betreiben eines Analog-Digital-Wandlers nach einem der Ansprüche 1 bis 3, **dadurch gekennzeichnet,** daß in der ersten Digitalisierungsstufe zur Digitalisierung des Signals die Anzahl der positiven und negativen Flußquantenübergänge im AC-SQUID durch Zählen der Spannungsimpulse an einem Josephson-Kontakt ausgenutzt wird.

5. Verfahren nach Anspruch 4, **dadurch gekennzeichnet,** daß in der ersten Digitalisierungsstufe durch die positiven und negativen Spannungsimpulse jeweils ein zusätzlicher Josephson-Kontakt oder ein zusätzliches DC-SQUID mit zwei oder mehr Josephson-Kontakten in den quasi-stationären Spannungszustand geschaltet wird.

6. Verfahren nach einem der Ansprüche 4 oder 5, **dadurch gekennzeichnet,** daß in der zweiten Digitalisierungsstufe die zwei DC-SQUID's mit dem gleichen zu wandelnden Signal angesteuert werden und bezüglich des zu wandelnden Signals gleichphasig oder gegenphasig angesteuert werden.

7. Verfahren nach einem der Ansprüche 4 bis 6, **dadurch gekennzeichnet,** daß in der zweiten Digitalisierungsstufe durch Überlagerung von zu wandelndem Signal und einem zusätzlichen Signal die beiden DC-SQUID's zu verschiedenen Zeitpunkten in den quasistationären Spannungszustand geschaltet werden und damit ein quasi-stationärer Spannungs- und Stromimpuls erzeugt wird, dessen Breite ein Maß für das zu wandelnde Signal darstellt und das durch Verknüpfung mit einem hochfrequenten Zähltakt mittels eines Zählers digitalisiert wird.

8. Verfahren nach einem der Ansprüche 4 bis 7, **dadurch gekennzeichnet,** daß in der zweiten Digitalisierungsstufe die von den beiden DC-SQUID's erzeugten Ausgangssignale gleich oder gegenphasig in ein mit einem hochfrequenten Zähltakt angesteuerten und als Torschaltung wirkenden SQUID mit zwei oder mehr Josephson-Kontakten induktiv oder galvanisch eingespeist wird.

9. Verfahren nach einem der Ansprüche 4 bis 8, **dadurch gekennzeichnet,** dass in der zweiten Digitalisierungsstufe das zusätzlich eingeschaltete Signal zusammen mit den zur Arbeitspunkteinstellung notwendigen Steuerströmen über Widerstände galvanisch in Deckoder Basiselektrode der DC-SQUID's eingespeist und das zu wandelnde Signal induktiv durch über den DC-SQUID's angeordneten Steuerleitungen eingekoppelt wird.

10. Verfahren nach einem der Ansprüche 4 bis 8, **dadurch gekennzeichnet,** dass in der zweiten Digitalisierungsstufe die zur Arbeitspunkteinstellung notwendigen Steuerströme induktiv durch über den DC-SQUID's angeordnete Steuerleitungen eingekoppelt werden.

**Claims**

1. Analogue-digital convertor with resistances, inductances and SQUIDs having one or more Josephson contacts in the superconductivity temperature range, characterized by:
   - a first digitizing stage comprising an AC-SQUID (6) having one (7) or more unequal Josephson contacts; and
   - a second digitizing stage comprising two DC-SQUIDs (2, 4) with two (3, 5) or more Josephson contacts;
   - a coupling between the two digitizing stages;
   - an apparatus for inputting periodic triangular signals; and
   - at least one counting device (12) for determining the number and/or width of the voltage pulses dependent on the analogue signal to be converted.

2. Analogue-digital convertor according to claim 1, characterized in that the first digitizing stage is coupled inductively to the second digitizing stage and the current is thereby restricted in the second digitizing stage to values which are less than or equal to the maximum Josephson current of the smallest of the Josephson contacts of the first digitizing stage.

3. Analogue-digital convertor according to either of claims 1 or 2, characterised in that it is integrated in a chip.

4. Process for operating an analogue to digital convertor according to any one of claims 1 to 3, characterized in that, in the first digitizing stage for digitizing the signal, the number of positive and negative flow quantum transitions in the AC-SQUID is utilized by counting the voltage pulses at a Josephson contact.

5. Process according to claim 4, characterized in that, in the first digitizing stage, one additional Josephson contact or one additional DC-SQUID with two or more Josephson contacts in the quasi-stationary voltage state is connected by the positive and negative voltage pulses in each case.

6. Process according to either of claims 4 or 5, characterized in that, in the second digitizing stage, the two DC-SQUIDs are triggered by the same signal which is to be converted and are triggered in phase or out of phase relative to the signal transformed.

7. Process according to any one of claims 4 to 6, characterized in that, in the second digitizing stage, the two DC-SQUIDS are put at different times into the quasi-stationary voltage state by superimposition of the signal which is to be converted and an additional signal and thus a quasi-stationary voltage and current pulse is generated of which the width is a measure for the signal to be converted and which is digitized by linkage with a high-frequency counting clock by means of a counter.

8. Process according to any one of claims 4 to 7, characterized in that, in the second digitizing stage, the output signals generated by the two DC-SQUIDS are inputted inductively or galvanically in phase or out of phase to a SQUID with two or more Josephson contacts which is triggered by a high-frequency counting pulse and acts as a gating circuit.

9. Process according to any one of claims 4 to 8, characterized in that, in the second digitizing stage, the signal additionally linked together with control currents necessary for setting the operating point are input galvanically via resistances in the covering or base electrode of the DC-SQUIDs and the signal to be converted is coupled inductively by control lines disposed over the DC-SQUIDs.

10. Process according to any one of claims 4 to 8, characterized in that, in the second digitizing stage, control currents necessary for adjusting the operating point are coupled inductively by control lines disposed over the DC-SQUIDs.

**Revendications**

1. Convertisseur analogique-numérique avec des résistances, des inductances et des SQUID's avec un ou plusieurs contacts de Josephson dans le domaine de température de la supraconductivité, **caractérisé en ce** qu'il comprend
   - un premier étage de numérisation composé d'un AC-SQUID (6) avec un (7) ou plusieurs contacts de Josephson de différentes dimensions et
   - un second étage de numérisation composé de deux DC-SQUID's (2, 4) avec deux (3, 5) contacts de Josephson ou plus,
   - un couplage entre les deux étages de numérisation,
   - un dispositif pour l'injection de signaux triangulaires périodiques, et
   - au moins un dispositif de comptage (12) pour la détermination du nombre et/ou de la largeur des impulsions de tension qui dépendent du signal analogique à convertir.

2. Convertisseur analogique-numérique selon la revendication 1, caractérisé en ce que le premier étage de numérisation est couplé de manière inductive avec le second étage de numérisation et que le courant dans le second étage de numérisation est ainsi limité à des valeurs inférieures ou égales au courant Josephson maximum du plus petit contact de Josephson du premier étage de numérisation.

3. Convertisseur analogique-numérique selon l'une des revendications 1 ou 2, caractérisé en ce qu'il est intégré dans une puce.

4. Procédé pour exploiter un convertisseur analogique-numérique selon l'une quelconque des revendications 1 à 3, caractérisé en ce que dans le premier étage de numérisation, le nombre des sauts de quanta de flux positifs et négatifs dans l'AC-SQUID est mis à profit pour la numérisation du signal en comptant les impulsions de tension sur un contact de Josephson.

5. Procédé selon la revendication 4, caractérisé en ce que dans le premier étage de numérisation, respectivement un contact de Josephson supplémentaire ou un DC-SQUID supplémentaire avec deux contacts de Josephson ou plus est commuté par les impulsions de tension positives et négatives sur l'état de tension quasi-stationnaire.

6. Procédé selon l'une des revendications 4 ou 5, caractérisé en ce que dans le second étage de numérisation, les deux DC-SQUID's sont commandés avec le même signal à convertir et qu'ils sont commandés en phase ou en opposition de phase par rapport au signal à convertir.

7. Procédé selon l'une quelconque des revendications 4 à 6, caractérisé en ce que dans le second étage de numérisation, les deux DC-SQUID's sont commutés à des instants différents sur l'état de tension quasi-stationnaire par la superposition du signal à convertir et d'un signal supplémentaire de manière à générer ainsi une impulsion de tension et de courant quasi-stationnaire dont la largeur représente un critère pour le signal à convertir lequel est numérisé par l'enchaînement avec une impulsion de comptage à haute fréquence au moyen d'un compteur.

8. Procédé selon l'une quelconque des revendications 4 à 7, caractérisé en ce que dans le second étage de numérisation, les signaux de sortie générés par les deux DC-SQUID's sont injectés de manière inductive ou conductive, en phase ou en opposition de phase, dans un SQUID avec deux contacts de Josephson ou plus qui agit en circuit porte et est commandé par une impulsion de comptage à haute fréquence.

9. Procédé selon l'une quelconque des revendications 4 à 8, caractérisé en ce que dans le second étage de numérisation, le signal supplémentaire est appliqué de manière conductive par l'intermédiaire de résistances, conjointement avec les courants de commande nécessaires pour le réglage du point de fonctionnement, à l'électrode de couverture ou de base des DC-SQUID's, et que le signal à convertir est couplé de manière inductive par des lignes pilotes disposées au-dessus des DC-SQUID's.

10. Procédé selon l'une quelconque des revendications 4 à 8, caractérisé en ce que dans le second étage de numérisation, les courants de commande nécessaires pour le réglage du point de fonctionnement sont couplés de manière inductive par des lignes pilotes disposées au-dessus des DC-SQUID's.

Fig. 1

Fig. 2 a

Fig. 2 b

Fig. 3